# EUROPEAN PATENT SPECIFICATION

(11) **EP 2 693 101 B1**
(45) Date of publication and mention of the grant of the patent: **04.01.2017**
(21) Application number: 13179062.8
(22) Date of filing: 02.08.2013
(51) Int. Cl.: F21K 99/00, F21S 9/03, F21W 131/103, B32B 17/10, F21L 4/08, H01L 31/048

(54) **Solar lighting system**
Solarbeleuchtungssystem
Système d'éclairage solaire

(30) Priority: 03.08.2012 CN 201210276362
(43) Date of publication of application: 05.02.2014
(73) Proprietor: Changzhou Almaden Co., Ltd., Changzhou, Jiangsu (CN)
(72) Inventor: Lin, Jinxi, Changzhou (CN); Lin, Jinhan, Changzhou (CN); Lin, Yuting, Wufeng Township; Taichung County (TW)
(74) Representative: 2K Patentanwälte Blasberg Kewitz & Reichel

(56) References cited:
- WO-A2-2010/141580
- WO-A2-2011/027277
- US-A1- 2008 137 327

## Description

### Field of the Invention

The present invention relates to a solar lighting system, and more particularly to an integrated system having a plurality of light-emitting lighting assemblies with high lighting performance and having a double-glass solar cell assembly.

### 2. Description of the Related Art

Solar energy is the most prevalently used source of environmentally friendly energy. Generally, solar energy is converted into electric energy by utilizing the photovoltaic effect of a solar cell.

The solar cell assembly is generally formed by combining a multilayered structure of glass, ethylene vinyl acetate (EVA), a photovoltaic component and a solar energy back sheet, and peripheral components such as an outer frame made of aluminum, galvanized steel sheet, wood and synthetic materials (such as polyethylene, (PE), polypropylene (PP) and ethylene propylene rubber), a junction box, lead wires, and a battery. Under sunlight irradiation, the solar cell assembly outputs a certain working voltage and working current through photovoltaic effect. Integrating a light-emitting lighting assembly with a solar cell assembly results in a more energy-efficient solar lighting system. Further, integrating a solar cell assembly with a light-emitting lighting assembly to form a solar lighting system can reduce the need for certain materials and allow production of Building-Integrated Photovoltaics, resulting in economical benefits.

WO 2010/141580 A2 is the closest state of the art document and discloses a solar-powered lighting module including a solar cell for generating electricity when exposed to light, a battery for storing charge from the generated electricity, and a light generating device powered by the stored charge. In an embodiment, the module further includes a controller that regulates the current transmitted between the components of the module. In a further embodiment, the module is incorporated into an interface to an environmentally controlled space and can be positioned to light an interior portion of the space. In another embodiment, the solar cell and light generating device are transparent to allow light to pass through the interface. In a further embodiment, tinted-color conjugated polymers incorporated into the module limit the spectrum of light that can pass through the interface. In yet another embodiment, a method of modifying an existing interface with such a module is provided.

WO 2011/027277 A2 discloses an illumination device comprising an at least partially transparent solar cell that is arranged at the back side of an at least partially transparent light source. Preferably, the light source is an OLED that is structured into a plurality of electroluminescent zones and inactive zones. The electroluminescent zones are preferably aligned with reflective zones of a mirror layer that is disposed between the light source and the solar cell.

US 2008/137327 A1 discloses a solution to add solar electric power generation to a streetlight which is attached to the power grid. The solution could either be a retro-fit to an existing streetlight, in which the solar panel and controller are attached as an option or a totally new design with integrated solar panel as part of the housing. The solution incorporates bi-directional power converter technology. This allows conversion of DC power from solar panels to AC for supplementing the power grid as well as AC to DC conversion to power a light.

The present invention provides a highly efficient and reliable solar lighting system.

### SUMMARY OF THE INVENTION

The objective of the present invention is to provide a solar lighting system comprising:
a solar cell assembly comprising a transparent glass front cover, a transparent encapsulating material, a transparent glass back sheet and photovoltaic components encapsulated by the transparent encapsulating material, wherein a gap allowing light penetration is provided between adjacent photovoltaic components;
a light-emitting lighting assembly, comprising a transparent glass front cover, a transparent encapsulating material, a transparent back sheet and one or a plurality of light-emitting diode components encapsulated by the transparent encapsulating material;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and the transparent back sheet of said light-emitting lighting assembly has a transparent conductive thin film layer pattern;
wherein said solar cell assembly is integrated with said light-emitting lighting assembly by a laminated glass encapsulation technique.

A further objective of the present invention is to provide a solar lighting system comprising:
a solar cell assembly comprising a transparent glass front cover, a transparent encapsulating material and a photovoltaic component encapsulated by the transparent encapsulating material;
a light-emitting lighting assembly, comprising a transparent encapsulating material, a transparent back sheet and one or a plurality of light-emitting diode components encapsulated by the transparent encapsulating material;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and said transparent back sheet has a transparent conductive thin film layer pattern;
wherein said solar cell assembly is integrated with said light-emitting lighting assembly by a laminated glass encapsulation technique: placing the photovoltaic component of said solar cell assembly, which lies between the transparent glass front cover and the transparent back sheet, and the light-emitting diode component of the light-emitting lighting assembly into the respective encapsulating materials, and separating said solar cell assembly and said light-emitting lighting assembly with a transparent encapsulating layer.

In another aspect, the present invention provides an individual solar lighting system by connecting the aforementioned solar lighting system to a DC to DC storage battery system.

In another aspect, the present invention provides a grid-connected solar lighting system by connecting the aforementioned solar lighting system to a municipal electricity grid through an inverter.

### BRIEF DESCRIPTION OF THE DRAWINGS

FIG. 1A is a schematic cross-sectional view of the solar cell assembly according to one embodiment of the present invention.
FIG. 1B is a schematic cross-sectional view of the light-emitting lighting assembly according to one embodiment of the present invention.
FIG. 2 is a schematic cross-sectional view of the solar lighting system according to one embodiment of the present invention.
FIG. 3 is a schematic cross-sectional view of the solar lighting system according to another embodiment of the present invention.
FIG. 4 is a schematic cross-sectional view of the solar lighting system according to another embodiment of the present invention.
FIG. 5 is a schematic cross-sectional view of the solar lighting system according to another embodiment of the present invention.
FIGs. 6A and 6B are schematic cross-sectional views of the solar lighting system according to another embodiment of the present invention.

### PREFERRED EMBODIMENT OF THE PRESENT INVENTION

In this context, unless otherwise limited, a singular term (such as "a") also includes a plural form thereof. In this context, all embodiments and exemplary terms (for example, "such as") only aim at making the present invention more prominent, but are not intended to limit the scope of the present invention; terms in this specification should not be construed as implying that any component not claimed may form a necessary component for implementing the present invention.

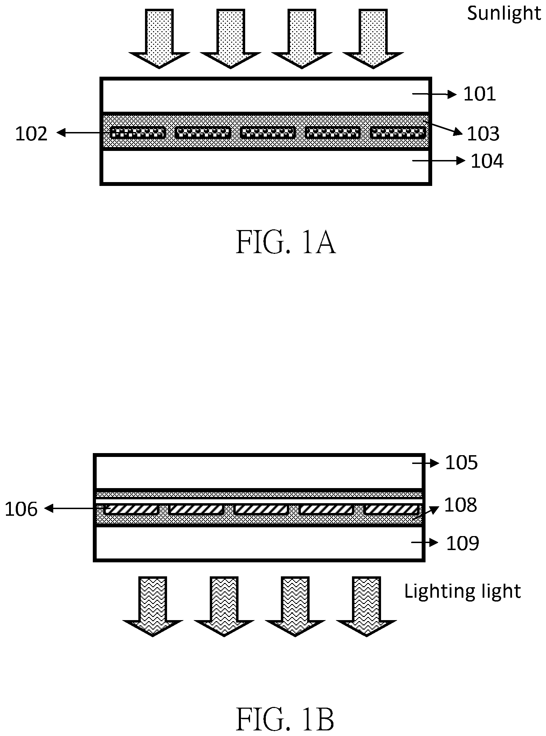

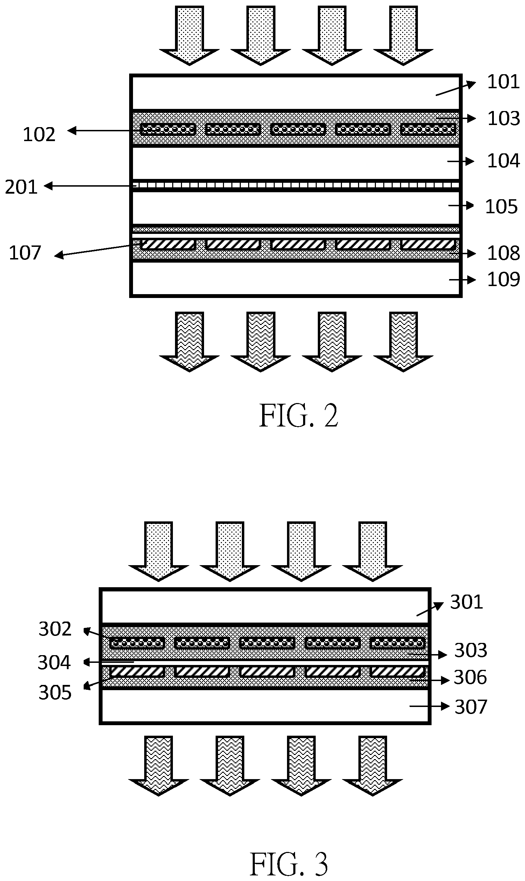

The present invention provides a solar lighting system comprising:
a solar cell assembly comprising a transparent glass front cover, a transparent encapsulating material, a transparent glass back sheet and a photovoltaic component encapsulated by the transparent encapsulating material; as shown in FIG. 1A, 101 is a transparent glass front cover, 102 is a photovoltaic component, 103 is a transparent encapsulating material, 104 is a transparent glass back sheet, and the arrow shows the incident direction of sunlight;
a light-emitting lighting assembly, comprising a transparent glass front cover, a transparent encapsulating material, a transparent back sheet and one or a plurality of light-emitting diode components encapsulated by the transparent encapsulating material; as shown in FIG.1B, 105 is a transparent glass front cover, 106 corresponds to light-emitting diode components, 108 is a transparent encapsulating material, 109 is a transparent back sheet, and the arrow shows the direction of the outgoing light;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and the transparent back sheet of said light-emitting lighting assembly has a transparent conductive thin film layer pattern;
wherein said solar cell assembly is integrated with said light-emitting lighting assembly by a laminated glass encapsulation technique. As shown in FIG. 2, the solar lighting system is an integration of the assemblies shown in FIG. 1A and FIG. 1B, wherein 107 corresponds to light-emitting diode components, 201 is a transparent adhesive material layer, and the laminated glass encapsulation technique includes lamination or rolling.

The present invention also provides a solar lighting system comprising:
a solar cell assembly comprising a transparent tempered glass front cover, a transparent encapsulating material and a photovoltaic component encapsulated by the transparent encapsulating material;
a light-emitting lighting assembly, comprising a transparent encapsulating material, a transparent back sheet and one or a plurality of light-emitting diode components encapsulated by the transparent encapsulating material;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and said transparent back sheet has a transparent conductive thin film layer pattern;
wherein said solar cell assembly is integrated with said light-emitting lighting assembly by a laminated glass encapsulation technique: placing the photovoltaic component of said solar cell assemblyt, which lies between the transparent glass front cover and the transparent back sheet, and the light-emitting diode component of the light-emitting lighting assembly into their respective encapsulating materials, and separating said solar cell assembly and said light-emitting lighting assembly with a transparent encapsulating layer. As shown in FIG. 3, 301 is a transparent glass front cover, 302 is a photovoltaic component, 303 and 306 are layers of transparent encapsulating materials, 304 is a transparent encapsulating layer, 305 is a light-emitting diode component, 307 is a transparent back sheet, the arrow above shows the incident direction of sunlight, and the arrow below shows the direction of the outgoing light.

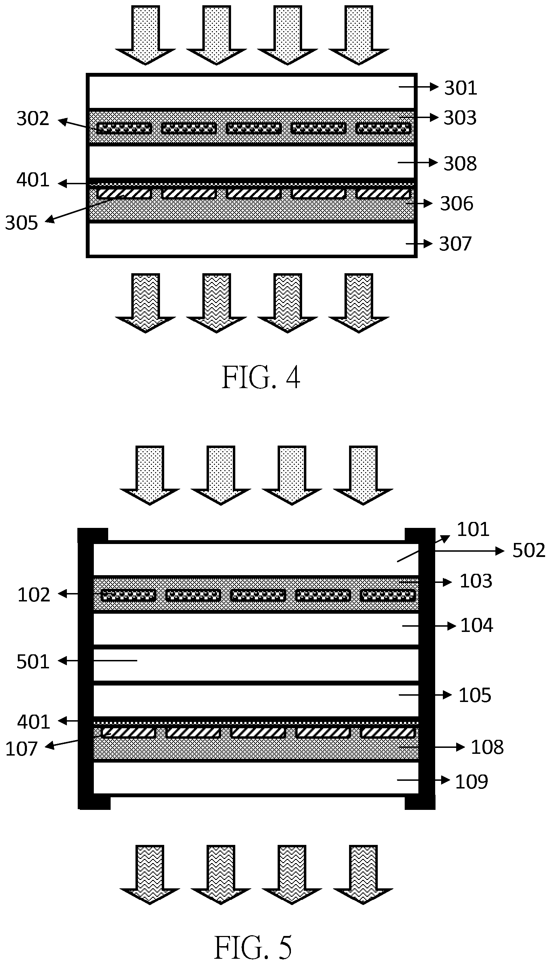

In one specific embodiment, a tempered glass may be used as the material for any one, any two or all of a transparent glass front cover, a transparent encapsulating layer and a transparent back sheet. Three of them or three tempered glasses are then formed into a sandwich structure by a laminated glass encapsulation technique, wherein the solar cell assembly and the light-emitting diode component are positioned into the encapsulating materials among the three tempered glasses. As shown in FIG. 4., 308 is a tempered glass, and 401 is a transparent conductive layer.

In another specific embodiment, the tempered glass used in the solar lighting system of the present invention is a physical tempered glass.

In another specific embodiment, said transparent encapsulating layer is a transparent conductive glass substrate of a thickness from 2.0mm to 0.7mm; and said substrate comprises a transparent conductive oxide thin film layer thereon, which may be a transparent thin film material of metal oxide such as ITO, IZO, IGZO, ZnO, SnO₂ or AZO.

In another specific embodiment, the integration of said solar cell assembly and said light-emitting lighting assembly is carried out by using an outer frame to fix the surrounding edge of the two assemblies to separate the two assemblies and form a sealed hollow chamber. Said sealed hollow chamber is used as a hollow layer to separate said two assemblies and provide effects such as heat preservation, sound insulation and heat insulation. The thickness of said solar cell assembly and said light-emitting lighting assembly is less than or equal to 5mm. As shown in FIG. 5, 501 is a hollow layer, 502 is a component (an outer frame) for fixing and sealing the edges. Said outer frame is made of aluminum, galvanized steel sheet, wood or synthesized materials such as polyethylene, polypropylene or ethylene propylene rubber.

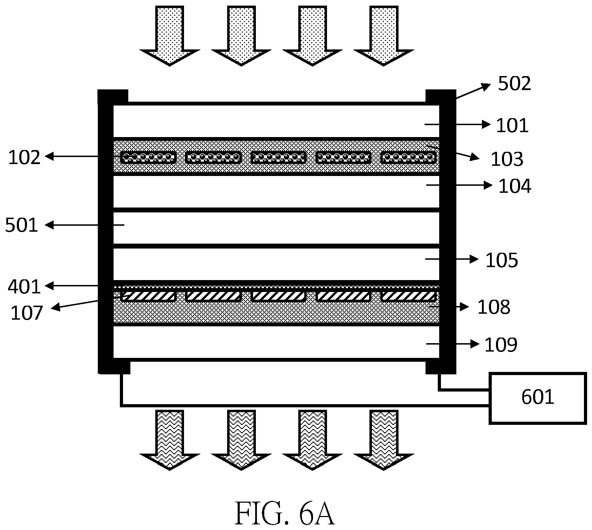

In another specific embodiment, said solar lighting system may be connected to a DC to DC storage battery system to form an individual solar lighting system. As shown in FIG. 6A, 601 is a storage battery.

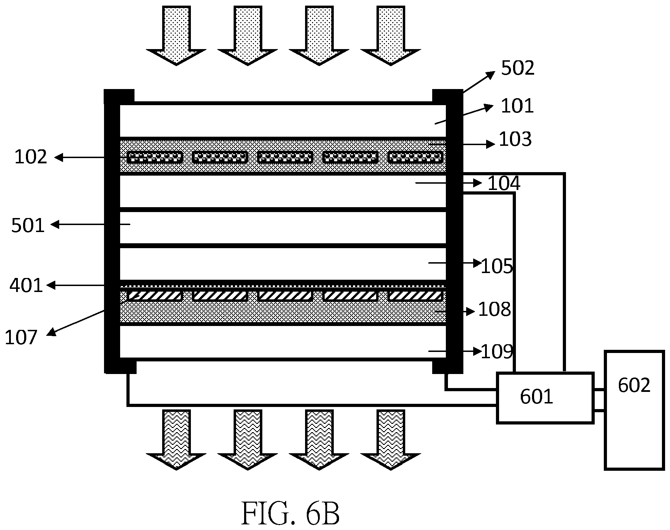

In another specific embodiment, the solar lighting system may be connected to a municipal electricity grid through an inverter to form a grid-connected solar lighting system. As shown in FIG. 6B, 602 is a municipal electricity grid.

Parts and technical features of the solar lighting system of the present invention are further illustrated below.

### Solar cell assembly

The solar cell assembly of the present invention may be any type of solar cell assembly. In addition to the front cover, the encapsulating material, the photovoltaic component, and the back sheet, the solar cell assembly of the present invention may include peripheral components such as an outer frame, an injunction box, lead wires, and a battery. All the peripheral components may be manufactured by means of conventional technology, and therefore are not described in any further detail in the present invention.

No special limitation is imposed on the front cover used in the solar cell assembly of the present invention; generally, a low reflective transparent glass plate is used, so as to provide sufficient light transmissive property and mechanical strength, such as compressive strength, tensile strength and hardness, and prevent moisture from entering the solar cell assembly.

The encapsulating material used in the solar cell assembly of the present invention is mainly for fixing the photovoltaic component of the solar cell and providing physical protection to the photovoltaic component, such as resisting shock and preventing moisture from entering. The encapsulating material in the solar cell assembly of the present invention may be made of any conventional material; currently, EVA is the most extensively used encapsulating material for a solar cell. EVA is a thermosetting resin, has properties such as high light transmission, heat resistance, low-temperature resistance, moisture resistance, and weather proofing after curing, has good adherence with metal, glass and plastic, and also has certain elasticity, shock resistance and heat conductivity, and therefore is an ideal solar cell encapsulating material.

No particular limitation is imposed on the photovoltaic component in the solar cell assembly of the present invention, which may be selected from various forms of photovoltaic components, such as a crystalline silicon photovoltaic component, a thin-film photovoltaic component, and a dye light-sensitive photovoltaic component.

In the solar cell assembly of the present invention, at least one part of the irradiation area of the transparent glass back sheet should not be covered by the photovoltaic component. The proportion left uncovered may be adjusted to accommodate particular conditions of its implementation, such as the conversion efficiency of the photovoltaic component, duration and intensity of sunlight, and the demand for electric power relative to that for thermal power. Generally, it would be appropriate that the amount covered is from 30% to 80%, preferably from 40% to 60%. In a specific embodiment, the photovoltaic component in the solar cell assembly may be a single or poly-crystalline silicon solar cell assembly or a thin film solar cell assembly.

In some embodiments, the back sheet in the solar cell assembly of the present invention may be simultaneously used as the front cover of the light-emitting lighting assembly. Therefore, it has to possess specific properties, in particular, excellent mechanical properties. Generally, an appropriate back sheet material should have compressive strength of at least about 120 MPa, bending strength of at least about 120 MPa and tensile strength of at least about 90 MPa.

A novel type of physical tempered glass, which may be made through treatment procedures such as aerodynamic heating and cooling, may be used as the transparent glass and light-emitting back sheet of the present invention. Specifically, this physical tempered glass may be made by performing heating in an aerodynamic-heating tempering furnace (such as a flatbed tempering furnace produced by LiSEC corporation) at a temperature ranging from about 600°C to about 750°C, preferably from about 630°C to about 700°C, and then performing rapid cooling through, for example, an air nozzle. In this context, the term "aerodynamic heating" refers to a process of transferring heat to an object through high-temperature gas generated when the object and air or other gases move at a high relative velocity. When the tempered glass is heated in the aerodynamic heating manner, the glass and the tempering furnace do not directly contact, so the glass is not deformed, and is suitable for thin glass. When the transparent glass and the light-emitting back sheet are transparent ultrathin tempered glass of a thickness less than 2.0mm, the physical tempered glass suitable for the present invention should have a compressive strength of about 120 MPa to 300MPa, preferably about 150MPa to 250MPa, a bending strength of about 120 MPa to about 300MPa, preferably about 150MPa to about 250MPa, and a tensile strength of about 90 MPa to 180 Mpa, preferably about 100MPa to about 150Mpa.

For a more detailed physical tempered glass preparation method, reference may be made to the content of Chinese Patent Application No. 201110198526.1 (corresponding to US Patent Application No. 13/541,995).

Normal glass does not have the requisite mechanical properties, either (for example, normal glass only has a tensile strength of about 40MPa), and thus cannot be applied to the present invention. Moreover, a conventional physically tempered glass might have sufficient mechanical properties, but must normally be over 3 millimeters thick to avoid deformation, which makes it heavy, and thus not only imposes an increased load on the light reflector but also makes it unsuitable for mounting on the roof of a residential building. As for conventional chemically tempered glass, it might meet the requisite mechanical properties and is not subject to the limitations imposed on thickness by machining. However, chemically tempered glass degrades very easily due to environmental factors, and has certain other disadvantages that limit its range of application, such as being difficult to coat, stripping easily and being costly.

### Light-emitting lighting assembly

The light-emitting lighting assembly of the present invention comprises a transparent glass front cover, transparent encapsulating material, transparent back sheet and one or a plurality of light-emitting diode components encapsulated by the transparent encapsulating material. Alternatively, when the back sheet of said solar cell assembly is used as the front cover of the light-emitting lighting assembly, the light-emitting lighting assembly of the present invention comprises a transparent encapsulating material, a transparent back sheet and one or a plurality of light-emitting diode components encapsulated by the transparent encapsulating material.

The transparent back sheet in the light-emitting lighting assembly of the present invention may be made of various materials, such as glass or plastic. The plastic material may be formed of one or more polymeric resin layers. The type of resin used for forming the polymeric resin layer is not particularly limited, and can be, for example, but not limited to, polyester resin, such as polyethylene terephthalate (PET) or polyethylene naphthalate (PEN); polyacrylate resin, such as polymethylmethacrylate (PMMA); polyolefin resin, such as polyethylene (PE) or polypropylene (PP); polystyrene resin; polycycloolefin resin; polyimide resin; polycarbonate resin (PC resin); polyurethane resin (PU resin); triacetate cellulose (TAC); polylactic acid; or a mixture thereof, and preferably is PET, PMMA, polycycloolefin resin, TAC, polylactic acid or a mixture thereof.

The surface of the transparent light-emitting back sheet described above has to be coated with a transparent conductive oxide thin film layer in order to transfer the current to the light-emitting lighting assembly on the substrate. The positive and negative electrodes of the light-emitting lighting assembly are attached to the transparent conductive oxide thin film layer by a conductive silver paste. When a voltage is applied, the current flows into the light-emitting lighting assembly to generate light. The transparent conductive oxide thin film layer is patterned into a specific pattern.

In one specific embodiment, the plurality of light-emitting diode components in the light-emitting lighting assembly may be placed according to the transparent conductive oxide thin film layer pattern on the transparent back sheet of said light-emitting lighting assembly.

In one specific embodiment, the plurality of light-emitting diode components in the light-emitting lighting assembly are placed on the transparent conductive PET substrate, which is separated from the solar cell assembly with a transparent encapsulating layer.

The objective of the solar lighting system provided in the present invention is to fully utilize the direct electricity converted from the photon energy by trapping the incident sunlight in the solar lighting system. To broaden the application field of solar lighting systems, the electricity system may be provided in two ways: one is to equip the solar lighting system with a storage battery system such as an extra DC to DC storage battery system to form an individual solar lighting system; and the other is to equip the solar lighting system with an inverter system to form a grid-connected solar lighting system which may be connected to a municipal electricity grid.

In another specific embodiment, to enhance the light-emitting efficiency of the solar lighting system, a reflective layer may be coated onto the surface of the transparent glass back sheet of said solar cell assembly or the surface of the transparent encapsulating layer, which lies between said solar cell assembly and said light-emitting lighting assembly, facing toward said solar cell assembly. Alternatively, a metal coating may be used as the reflective layer. The main function of this reflective layer is to reflect the full-spectrum light. Therefore, there is no limitation as to the material employed for making such reflective layer. Preferably, it may be made of metals such as silver, gold, aluminum or chromium. Metal oxides or non-metal materials are also applicable. Materials such as TiO₂, BaSO₄ Teflon are preferred since their white appearance can improve light reflection. In addition to the function of reflecting full-spectrum light, such reflective layer can also reflect sunlight back to the solar cell assembly, thereby improving efficiency of energy generation. Any suitable method can be applied to the integration of the reflective layer to the solar cell assembly or the light-emitting lighting assembly, such as adhesion with adhesives. When the reflective layer is metal, it is preferred to directly deposit the metal onto the glass substrate by physical vapor deposition. An adhesive is not needed in such process, so not only is the process simplified, but also problems resulting from adhesive deterioration is prevented. Reliability is improved, accordingly. The wavelength of the reflective layer is in a range of 380nm and 780nm, preferably in a range of 450nm and 700nm, more preferably in a range of 500nm and 650nm, and the average reflectivity is greater than 70%.

It will be apparent to those skilled in the art that various modifications and variations can be made to the structure of the present invention without departing from the scope of the appended claims In view of the foregoing, it is intended that the present invention covers modifications and variations of this invention provided they fall within the scope of the following claims .

## Claims

1. A solar lighting system comprising:
a solar cell assembly comprising a transparent glass front cover, a transparent encapsulating material, a transparent glass back sheet and a photovoltaic component encapsulated by the transparent encapsulating material;
a light-emitting lighting assembly, comprising a transparent glass front cover, a transparent encapsulating material, a transparent back sheet and one or a plurality of light-emitting diode components encapsulated by the transparent encapsulating material;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and the transparent back sheet of said light-emitting lighting assembly has a transparent conductive thin film layer pattern;
wherein said solar cell assembly is integrated with said light-emitting assembly by a laminated glass encapsulation technique.

2. The solar lighting system according to Claim 1 or 8, wherein the transparent glass front cover, transparent glass back sheet and transparent back sheet are physical tempered glasses and/or wherein said tempered glass is a physical tempered glass

3. The solar lighting system according to Claim 2, wherein the physical tempered glass has compressive strength ranging from about 120 MPa to about 300 MPa, bending strength ranging from about 120 MPa to about 300 MPa, and tensile strength ranging from about 90 MPa to about 180 MPa.

4. The solar lighting system according to Claim 1, wherein said solar cell assembly is attached to said light-emitting lighting assembly by a transparent adhesive to form a transparent encapsulating layer between these two assemblies.

5. The solar lighting system according to Claim 1, wherein a large area of a light-emitting back sheet is formed on the transparent back sheet of said light-emitting lighting assembly.

6. A solar lighting system comprising:
a solar cell assembly comprising a transparent glass front cover, a transparent encapsulating material and a photovoltaic component encapsulated by the transparent encapsulating material;
a light-emitting lighting assembly, comprising a transparent encapsulating material, a transparent back sheet and one or a plurality of light-emitting diode components encapsulated by the transparent encapsulating material;
wherein said light-emitting diode component is located on the transparent back sheet of the light-emitting lighting assembly to form a light-emitting back sheet; said light-emitting diode component may be a light-emitting diode component for a dot light source or an organic light-emitting diode component for a plane light source; and said transparent back sheet has a transparent conductive thin film layer pattern;
wherein said solar cell assembly is integrated with said light-emitting lighting assembly by a laminated glass encapsulation technique: placing the photovoltaic component of said solar cell assembly, which lies between the transparent glass front cover and the transparent back sheet, and the light-emitting diode component of the light-emitting lighting assembly into the respective encapsulating materials, and separating said solar cell assembly and said light-emitting lighting assembly with a transparent encapsulating layer.

7. The solar lighting system according to Claim 6, wherein the transparent glass front cover and/or transparent back sheet are transparent tempered glasses.

8. The solar lighting system according to Claim 7, wherein the integration of said solar cell assembly and said light-emitting lighting assembly may be carried out by using a tempered glass as said transparent encapsulating layer and applying the laminated glass encapsulation technique to make three tempered glasses into a sandwich structure; placing the photovoltaic component of said solar cell assembly and the light-emitting diode component of said light-emitting lighting assembly into the respective encapsulating materials; and separating said solar cell assembly and said light-emitting lighting assembly by using the shared transparent tempered glass.

9. The solar lighting system according to Claim 1 or 6, wherein the integration of said solar cell assembly and said light-emitting lighting assembly is carried out by using an outer frame to fix the surrounding edge of the two assemblies to separate the two assemblies and form a sealed hollow chamber, wherein said sealed hollow chamber may be used to separate said two assemblies and used as a hollow layer; and the thicknesses of said solar cell assembly and said light-emitting lighting assembly are each less than or equal to 5 mm.

10. The solar lighting system according to Claim 1 or 6, wherein the plurality of light-emitting diode components may be placed according to the transparent conductive thin film layer pattern on the transparent back sheet of said light-emitting lighting assembly, wherein the transparent back sheet of said light-emitting lighting assembly may be a glass substrate or a plastic substrate such as PET substrate, PE substrate, PC substrate or PU substrate.

11. The solar lighting system according to Claim 10, the transparent back sheet of the light-emitting lighting assembly is a PET substrate, and said substrate is separated from said solar cell assembly with one transparent encapsulating layer.

12. The solar lighting system according to Claim 6, wherein said transparent encapsulating layer is a transparent conductive glass substrate of a thickness from 2.0mm to 0.7mm; and said substrate comprises a transparent conductive oxide thin film layer, which may be a transparent metal oxide thin film material such as ITO, IZO, IGZO, ZnO, SnO₂ or AZO.

13. The solar lighting system according to Claim 9, wherein the surrounding edge of the two assemblies may be fixed by an outer frame made of aluminum, zinc-coated steel sheet, wood or synthesized materials selected from polyethylene, polypropylene and ethylene propylene rubber.

14. The solar lighting system according to Claims 1 or 6 being connected to a DC to DC storage battery system to form an individual solar lighting system or being connected to a municipal electricity grid through an inverter to form a grid-connected solar lighting system.

15. The solar lighting system according to Claim 1 or 6, wherein the surface of the transparent glass back sheet of said solar cell assembly or the surface of the transparent encapsulating layer between said solar cell assembly and said light-emitting lighting assembly facing toward said solar cell assembly is coated with a reflective layer, which is selected from the group consisting of silver, gold, aluminum, chromium, TiO₂, BaSO₄ and Teflon.

16. The solar lighting system according to Claim 15, wherein the wavelength of said reflective layer is from 380nm to 780nm, preferably from 450nm to 700nm, more preferably from 500nm to 650nm, and the average reflectivity is greater than 70%.

17. The solar lighting system according to Claim 15, wherein said reflective layer is a metal coating, and said metal may be selected from a group consisting of silver, gold, aluminum and chromium.

## Patentansprüche

1. Solarbeleuchtungssystem umfassen:
Eine Solarzellenanordnung umfassend eine transparente Glasfrontabdeckung, ein transparentes Verkapselungsmaterial, eine transparente Glasrückplatte und eine photovoltaische Komponente, die durch das transparente Verkapselungsmaterial eingekapselt ist;
eine lichtemittierende Beleuchtungsanordnung umfassend eine transparente Glasfrontabdecküng, ein transparentes Verkapselungsmaterial, eine transparente Rückplatte und eine oder mehrere lichtemittierende Diodenkomponenten, die durch das transparente Verkapselungsmaterial eingekapselt sind;
wobei die genannte lichtemittierende Diodenkomponente auf der transparenten Rückplatte der lichtemittierenden Beleuchtungsanordnung angeordnet ist, um eine lichtemittierende Rückplatte zu bildern; die genannte lichtemittierende Diodenkomponente kann eine lichtemittierende Diodenkomponente für eine Punkt Lichtquelle oder eine organische lichtemittierende Diodenkomponente für eine ebene Lichtquelle sein; und die transparente Rückplatte der genannten lichtemittierenden Beleuchtungsanordnung weist ein transparentes, leitendes dünnes Filmschichtmuster auf;
wobei die genannte Solarzellenanordnung mit der genannten lichtemittierenden Anordnung durch eine laminierte Glasverkapselungstechnik integriert ist.

2. Das Solarbeleuchtungssystem nach Anspruch 1, wobei die transparente Glasfrontabdeckung, die transparente Glasrückplatte und die transparente Rückplatte physikalisch gehärtete Gläser sind und / oder wobei das genannte gehärtete Glas ein physikalisches gehärtetes Glas ist.

3. Das Solarbeleuchtungssystem nach Anspruch 2, wobei das physikalisch gehärtete Glas eine Druckfestigkeit im Bereich von etwa 120 MPa bis etwa 300 MPa, eine Biegefestigkeit im Bereich von etwa 120 MPa bis etwa 300 MPa und eine Zugfestigkeit im Bereich von etwa 90 MPa bis Etwa 180 MPa aufweist.

4. Das Solarbeleuchtungssystem nach Anspruch 1, wobei die genannt Solarzellenanordnung durch einen transparenten Kleber an der genannten lichtemittierenden Beleuchtungsanordnung befestigt ist, um zwischen diesen beiden Anordnungen eine transparente Verkapselungsschicht zu bildern.

5. Das Solarbeleuchtungssystem nach Anspruch 1, wobei ein großer Bereich einer lichtemittierenden Rückplatte auf der transparenten Rückplatte der genannten lichtemittierenden Beleuchtungsanordnung gebildet wird.

6. Das Solarbeleuchtungssystem umfassend:
eine Solarzellenanordnung umfassend eine transparente Glasfrontabdeckung, ein transparentes Verkapselungsmaterial und eine photovoltaische Komponente, die durch das transparente Verkapselungsmaterial eingekapselt ist;
eine lichtemittierende Beleuchtungsanordnung, umfassend ein transparentes Verkapselungsmaterial, eine transparente Rückplatte und eine oder mehrere lichtemittierende Diodenkomponenten, die durch das transparente Verkapselungsmaterial eingekapselt sind;
wobei die genannte lichtemittierende Diodenkomponente auf der transparenten Rückplatte der lichtemittierenden Beleuchtungsanordnung angeordnet ist, um eine lichtemittierende Rückplatte zu bilden; die genannte lichtemittierende Diodenkomponente kann eine lichtemittierende Diodenkomponente für eine Punktquelle des Lichts oder eine organische lichtemittierende Diodenkomponente für eine ebene Lichtquelle sein; und die genannte transparente Rückplatte weist ein transparentes, dünnes Filmschichtmuster auf;
wobei die genannte Solarzellenanordnung mit der lichtemittierenden Beleuchtungsanordnung durch eine laminierte GlasVerkapselungstechnik integriert ist: Anordnen der photovoltaischen Komponente der genannten Solarzellenanordnung, die zwischen der transparenten Glasfrontabdeckung und der transparenten Rückplatte und der lichtemittierenden Diodenkomponente der lichtemittierenden Beleuchtungsanordnung in die jeweiligen Verkapselungsmaterialien liegt, und Trennen der genannten Solarzellenanordnung und der genannten lichtemittierende Beleuchtungsanordnung mit einer transparenten Verkapselungsschicht.

7. Das Solarbeleuchtungssystem nach Anspruch 6, wobei die transparente Glasfrontabdeckung und / oder die transparente Rückplatte transparente gehärtete Gläser sind.

8. Das Solarbeleuchtungssystem nach Anspruch 7, wobei die Integration der genannten Solarzellenanordnung und der genannten lichtemittierenden Beleuchtungsanordnung unter Verwendung eines gehärteten Glases als besagte transparente Verkapselungsschicht durchgeführt werden kann und Aufbringen der laminierten Glasverkapselungstechnik, um drei gehärtete Gläser in einer Sandwichstruktur zusammenzuführen; Anordnen der photovoltaischen Komponente der Solarzellenanordnung und der lichtemittierenden Diodenkomponente der genannten lichtemittierenden Beleuchtungsanordnung in den jeweiligen Verkapselungsmaterialien; und Trennen der genannten Solarzellenanordnung und der genannten lichtemittierenden Beleuchtungsanordnung unter Verwendung des geteilten transparenten gehärteten Glases.

9. Das Solarbeleuchtungssystem nach Anspruch 1 oder 6, wobei die Integration der genannten Solarzellenanordnung und der genannten lichtemittierenden Beleuchtungsanordnung unter Verwendung eines äußeren Rahmens ausgeführt wird, um die umgebende Kante der beiden Anordnungen zu befestigen, um die beiden Anordnungen zu trennen und eine abgedichtete Hohlkammer zu bilden, wobei die genannte abgedichtete Hohlkammer verwendet werden kann, um die beiden Anordnungen zu trennen und als Hohlschicht verwendet zu werden; und die Dicken der genannten Solarzellenanordnung und die genannte lichtemittierenden Beleuchtungsanordnung jeweils kleiner oder gleich 5 mm sind.

10. Das Solarbeleuchtungssystem nach einem der Ansprüche 1 bis 6, wobei die Mehrzahl von lichtemittierenden Diodenkomponenten gemäß dem transparenten leitfähigen dünnen Filmschichtmuster auf der transparenten Rückplatte der lichtemittierenden Beleuchtungsanordnung platziert werden kann, wobei die transparente Rückplatte der lichtemittierenden Beleuchtungsanordnung ein Glassubstrat oder ein Kunststoffsubstrat wie PET-Substrat, PE-Substrat, PGSubstrat oder PU-Substrat sein kann.

11. Das Solarbeleuchtungssystem nach Anspruch 10, wobei die transparente Rückplatte der lichtemittierenden Beleuchtungsanordnung ein PET-Substrat ist und das genannte Substrat ist von der genannten Solarzellenanordnung mit einer transparenten Verkapselungsschicht getrennt.

12. Das Solarbeleuchtungssystem nach Anspruch 6, wobei die genannte transparente Verkapselungsschicht ein transparentes leitfähiges Glassubstrat mit einer Dicke von 2,0 mm bis 0,7 mm ist; und das genannte Substrat umfasst eine transparente, leitfähige Oxid-Dünnfilmschicht, die ein transparentes Metalloxid-Dünnflmmaterial wie ITO, IZO, IGZO, ZnO, SnO₂ oder AZO sein kann.

13. Das Solarbeleuchtungssystem nach Anspruch 9, wobei die umgebende Kante der beiden Anordnungen durch einen Außenrahmen aus Aluminium, verzinktem Stahlblech, Holz oder synthetischen Materialien, ausgewählt aus Polyethylen, Polypropylen und Ethylenpropylenkautschuk, fixiert ist.

14. Das Solarbeleuchtungsanlage nach einem der Ansprüche 1 oder 6, die mit einem DC-DC-Akkumulatorsystem verbunden ist, um ein individuelles Solarbeleuchtung ssystem zu bilden, oder über einen Wechselrichter mit einem städtischen Stromnetz verbunden ist, um eine netzgekoppelte Solarbeleuchtungsanlage zu bilden.

15. Das Solarbeleuchtungssystem nach Anspruch 1 oder 6, wobei die Oberfläche der transparenten Glasrückplatte der Solarzellenanordnung oder die Oberfläche der transparenten Verkapselungsschicht zwischen der genannten Solarzellenanordnung und der genannten lichtemittierenden Beleuchtungsanordnung, die der genannten Solarzellenanordnung zugewandt ist, mit einer reflektierenden Schicht beschichtet ist, die aus der Gruppe bestehend aus Silber, Gold, Aluminium, Chrom, TiO₂, BaSO₄ und Teflon ausgewählt ist.

16. Das Solarbeleuchtungssystem nach Anspruch 15, wobei die Wellenlänge der genannten reflektierenden Schicht von 380 nm bis 780 nm, vorzugsweise von 450 nm bis 700 nm, bevorzugter von 500 nm bis 650 nm und das durchschnittliche Reflexionsvermögen größer als 70% ist.

17. Das Solarbeleuchtungssystem nach Anspruch 15, wobei die genannte reflektierende Schicht eine Metallbeschichtung ist und das genannte Metall aus einer Gruppe bestehend aus Silber, Gold, Aluminium und Chrom ausgewählt werden kann.

## Revendications

1. Un système d'éclairage solaire comprenant:
un assemblage de cellule solaire comprenant un couvercle avant en verre transparent, un matériau d'encapsulage transparent, une feuille arrière en verre transparent et un composant photovoltaïque encapsulé par le matériau d'encapsulage transparent ;
un ensemble d'émission de lumière d'éclairage, comprenant un couvercle avant en verre transparent, un matériau d'encapsulage transparent, une feuille arrière transparente et une ou une pluralité de composants à diodes émetteurs de lumière encapsulés par le matériau d'encapsulage transparent ;
dans lequel ledit composant à diode émetteur de lumière est situé sur la feuille arrière transparente de l'ensemble d'émission de lumière d'éclairage pour former une feuille arrière émettrice de lumière, ledit composant à diode émetteur de lumière pouvant être un composant à diode émetteur de lumière pour une source lumineuse ponctuelle ou un composant à diode émetteur de lumière organique pour une source lumineuse plane ; et la feuille arrière transparente dudit ensemble d'émission de lumière d'éclairage ayant un motif de couche en film mince conductrice transparente ;
dans lequel ledit assemblage de cellule solaire est intégré avec ledit ensemble d'émission de lumière au moyen d'une technique d'encapsulation de verre feuilleté.

2. Le système d'éclairage solaire selon la revendication 1 ou 8, dans lequel le couvercle avant en verre transparent, la feuille arrière en verre transparent et la feuille arrière transparent sont des verres trempés physiques et / ou dans lequel ledit verre trempé est un verre trempé physique.

3. Le système d'éclairage solaire selon la revendication 2, dans lequel le verre trempé physique a une résistance à la compression allant d'environ 120 MPa à environ 300 MPa, une résistance à la flexion allant d'environ 120 MPa à environ 300 MPa, et une résistance à la traction allant d'environ 90 MPa à environ 180 MPa.

4. Le système d'éclairage solaire selon la revendication 1, dans lequel ledit ensemble de cellule solaire est fixé audit ensemble d'émission de lumière d'éclairage au moyen d'un adhésif transparent pour former une couche d'encapsulation transparente entre ces deux ensembles.

5. Le système d'éclairage solaire selon la revendication 1, dans lequel une grande surface d'une feuille arrière émettrice de lumière est formée sur la feuille arrière transparente dudit dispositif d'éclairage émettant de la lumière.

6. Un système d'éclairage solaire comprenant:
un assemblage de cellule solaire comprenant un couvercle avant en verre transparent, un matériau d'encapsulage transparent et un composant photovoltaïque encapsulé par le matériau d'encapsulage transparent ;
un ensemble d'émission de lumière d'éclairage, comprenant un matériau d'encapsulage transparent, une feuille arrière transparente et une ou une pluralité de composants à diodes émetteurs de lumière encapsulés par le matériau d'encapsulage transparent ;
dans lequel ledit composant à diode émetteur de lumière est situé sur la feuille arrière transparente de l'ensemble d'émission de lumière d'éclairage pour former une feuille arrière émettrice de lumière, ledit composant à diode émetteur de lumière pouvant être un composant à diode émetteur de lumière pour une source lumineuse ponctuelle ou un composant à diode émetteur de lumière organique pour une source lumineuse plane; et la feuille arrière transparente ayant un motif de couche en film mince conductrice transparente ;
dans lequel ledit assemblage de cellule solaire est intégré avec ledit ensemble d'émission de lumière au moyen d'une technique d'encapsulation de verre feuilleté :
placer le composant photovoltaïque dudit assemblage de cellule solaire, qui est posé entre le couvercle avant en verre transparent et la feuille arrière transparente, et le composant à diode émetteur de lumière de l'ensemble d'émission de lumière d'éclairage dans les matériaux d'encapsulation respectifs, et en séparant ledit assemblage de cellule solaire et ledit ensemble d'émission de lumière d'éclairage au moyen d'une couche d'encapsulation transparente.

7. Le système d'éclairage solaire selon la revendication 6, dans lequel le couvercle avant en verre transparent et / ou la feuille arrière transparente sont des verres trempés transparents.

8. Le système d'éclairage solaire selon la revendication 7, dans lequel l'intégration dudit ensemble de cellule solaire et dudit ensemble d'émission de lumière d'éclairage peut être réalisée en utilisant un verre trempé, en tant que ladite couche d'encapsulation transparente et en appliquant la technique d'encapsulation en verre feuilleté pour faire trois une structure de sandwich comportant trois verres trempés; placer le composant photovoltaïque dudit ensemble de cellule solaire et le composant à diode d'émission de lumière dudit dispositif d'éclairage émettant de la lumière dans les matériaux d'encapsulation respectifs ; et séparer ledit assemblage de cellule solaire et ledit ensemble d'émission de lumière d'éclairage en utilisant le verre transparent commun.

9. Le système d'éclairage solaire selon la revendication 1 ou 6, dans lequel l'intégration dudit ensemble de cellule solaire et ledit ensemble d'émission de lumière d'éclairage est réalisée à l'aide d'un cadre extérieur pour fixer le bord périphérique des deux ensembles pour séparer les deux ensembles et pour former une cavité creuse fermée, dans lequel ladite cavité creuse scellée peut être utiliser pour séparer lesdits ensembles et utilisée en tant que couche creuse; et les épaisseurs dudit assemblage de cellule solaire et dudit ensemble d'éclairage émettant de la lumière sont chacune inférieures ou égales à 5 mm.

10. Le système d'éclairage solaire selon la revendication 1 ou 6, dans lequel la pluralité de composants à diode émetteurs de lumière peut être placée sur la feuille arrière transparente dudit ensemble d'émission de lumière d'éclairage selon le motif de couche de film mince conductrice transparente , dans lequel la feuille arrière transparente dudit ensemble d'émission de lumière d'éclairage peut être un substrat de verre, ou un substrat plastique tel qu'un substrat PET, un substrat PC ou un substrat PU.

11. Le système d'éclairage solaire selon la revendication 10, la feuille arrière transparente de l'ensemble d'émission de lumière d'éclairage est un substrat de PET, et ledit substrat est séparé dudit assemblage de cellule solaire au moyen d'une couche d'encapsulation transparente.

12. Le système d'éclairage solaire selon la revendication 6, dans lequel ladite couche d'encapsulation transparente est un substrat en verre conducteur transparent d'une épaisseur de 2,0 mm à 0,7 mm; et ledit substrat comprend une couche de film mince d'oxyde transparent conducteur, qui peut être un matériau mince de film d'oxyde métallique transparent tel que l'ITO, l'IZO, IGZO, ZnO, SnO₂or azoïque.

13. Le système d'éclairage solaire selon la revendication 9, dans lequel le bord périphérique des deux ensembles peut être fixé par un cadre extérieur en aluminium, tôle d'acier revêtue de zinc, en bois ou en matériaux synthétiques choisis parmi le polyéthylène, le polypropylène et le caoutchouc éthylène-propylène.

14. Le système d'éclairage solaire selon les revendications 1 ou 6 étant relié à un système de batterie d'accumulateurs à courant continu à courant continu pour former un système d'éclairage solaire individuel ou étant connecté à un réseau local d'électricité par l'intermédiaire d'un onduleur pour former un système d'éclairage solaire raccordé au réseau.

15. Le système d'éclairage solaire selon la revendication 1 ou 6, dans lequel la surface de la feuille arrière transparente dudit assemblage de cellule solaire ou la surface de la couche d'encapsulation transparente entre ledit ensemble de cellule solaire et ledit ensemble d'éclairage émettant de la lumière, faisant face à l'assemblage de cellule solaire, est recouvert d'une couche réfléchissante, qui est choisie au sein du groupe constitué par l'argent, l'or, l'aluminium, le chrome, le TiO₂, BaSO₄ et du téflon.

16. Le système d'éclairage solaire selon la revendication 15, dans lequel la longueur d'onde de ladite couche réfléchissante est comprise entre 380 nm à 780 nm, de préférence de 450m à 700nm, plus préférablement de 500 nm à 650 nm, et la réflectivité moyenne est supérieure à 70%.

17. Le système d'éclairage solaire selon la revendication 15, dans lequel ladite couche réfléchissante est une couche métallique, et ledit métal peut être choisi au sein d'un groupe constitué par l'argent, l'or, l'aluminium et du chrome.
